# EUROPEAN PATENT APPLICATION

(11) **EP 0 833 343 A2**
(43) Date of publication of application: **01.04.1998**
(21) Application number: 97116881.0
(22) Date of filing: 29.09.1997
(51) Int. Cl.: G11C 8/00

(54) **A NOR gate applied to a sub-decoder of a semiconductor memory**

(30) Priority: 30.09.1996 JP 278934/96
(71) Applicant: NEC CORPORATION, Tokyo (JP)
(72) Inventor: Miki, Atsunori, Minato-ku, Tokyo (JP)
(74) Representative: Glawe, Delfs, Moll & Partner

(57) **Abstract**

To eliminate the momentary drop of the positive power supply due to instantaneous discharge of floating nodes of NOR gates in a sub-decoder to improve rising up of word lines of a semiconductor memory, a NOR gate of the invention comprises a serial connection of two pMOS transistors (MP1 and MP2), a parallel connection of two nMOS transistors (MN1 and MN2) and a nMOS transistor (MN3) for bypassing floating charge of connection point of the two pMOS transistors. The serial connection of the pMOS transistors and the parallel connection of the nMOS transistors are connected between a positive power supply (Vcc) and a negative power supply (Vss). A main decoder signal (S1) gates one of the pMOS transistors connected to the positive power supply, one of the parallel connection of the nMOS transistors and the nMOS transistor for bypassing the floating charge. A pre-decoder signal (S2) gates other MOS transistors. A word line (WL) is connected to connection point between serial connection of the pMOS transistors and the parallel connection of the nMOS transistors.

## Description

The present invention relates to a NOR gate applied for a sub-decoder which drives word lines of a semiconductor memory cell array.

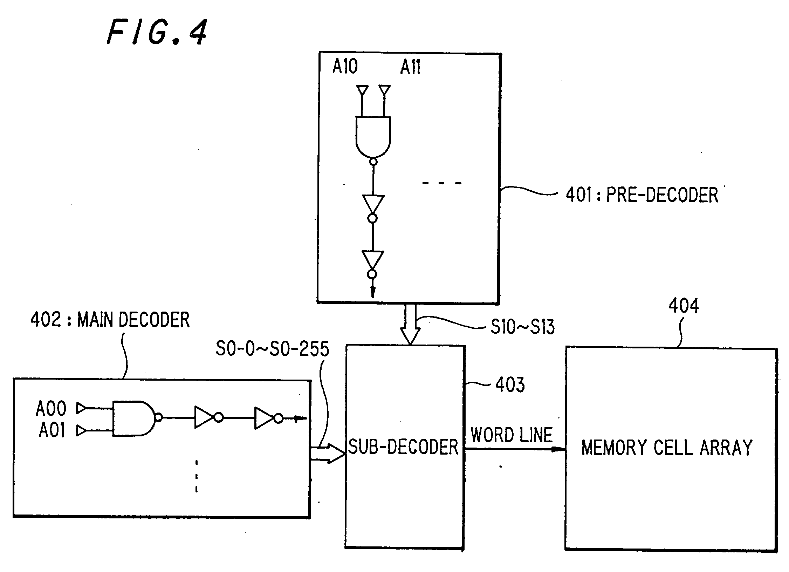

FIG. 4 is a block diagram illustrating a typical configuration of a decoder circuit for driving word lines of a memory cell array.

Referring to FIG. 4, this decoder circuit consists of a hierarchical composition of a pre-decoder 401, a main decoder 402 and a sub-decoder 403 which is provided for each memory cell array 404 of a semiconductor memory.

When the memory cell array 404 has 2¹⁰ word lines corresponding to ten bits of a word line address signal, the pre-decoder 401 and the main decoder 402, composed of NOR gates and inverters, for example, decode the word line address signal for outputting four pre-decoder signals S10 to S13 corresponding to two bits A10 and A11 of the ten bits and 256 main decoder signals S0-0 to S0-255 corresponding to other eight bits A00 to A07 of the ten bits, respectively, to be supplied to the sub-decoder 403. One of the pre-decoder signals S10 to S13 and one of the main decoder signals S0-0 to S0-255 become at logic LOW when a word line is indicated by the ten bits A10, A11 and A01 to A07, and the corresponding memory cell array 404 is indicated by other bits of the word line address signal than the ten bits, so as to make the word line active. Therefore, load capacitance of a word line, which is made active only in a selected memory cell array, can be designed to be small with the decoder circuit of FIG. 4.

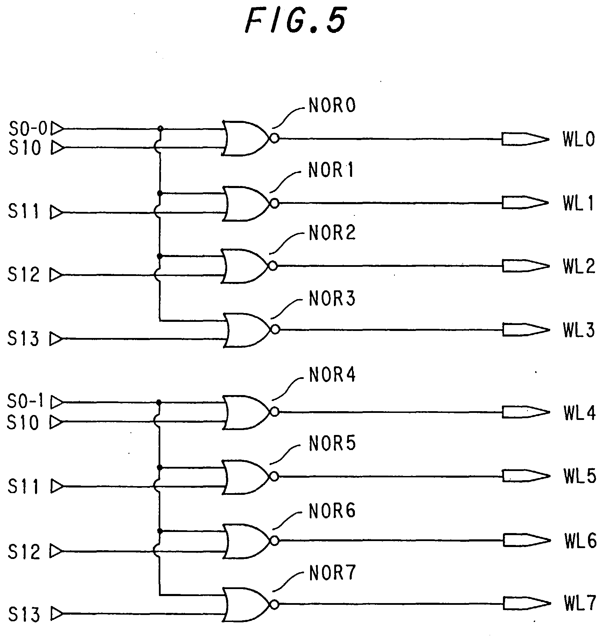

FIG. 5 is a circuit diagram illustrating a part of the sub-decoder 403 where the four pre-decoder signals S10 to S13 and two (S0-0 and S0-1) of the main decoder signals are supplied.

Referring to FIG. 5, the sub-decoder 403 comprises eight NOR gates NOR0 to NOR7. Each of the NOR gates NOR0 to NOR3 makes active corresponding each of word lines WL0 to WL3 according to NOR logic of the main decoder signal S0-0 and each of the pre-decoder signals S10 to S13 supplied thereto, and each of the NOR gates NOR4 to NOR7 makes active corresponding each of word lines WL4 to WL7 according to NOR logic of the main decoder signal S0-1 and each of the pre-decoder signals S10 to S13, in the same way.

When none of the word lines WL0 to WL7 is selected, both of the main decoder signals S0-0 and S0-1 are at logic HIGH, or every of the pre-decoder signals S10 to S13 is at logic HIGH.

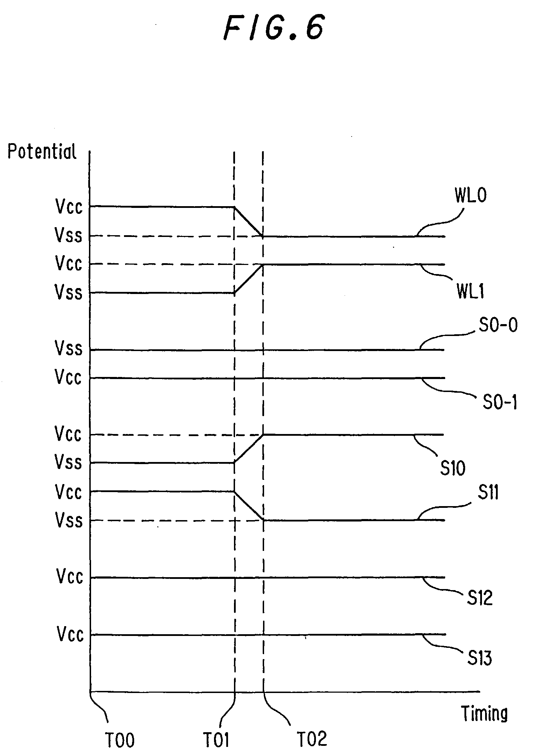

FIG. 6 is a timing chart illustrating a transition of logic of the main decoder signals S0-0 and S0-1 and the pre-decoder signals S10 to S13 when the selected word line changes from the word line WL0 to the word line WL1.

Referring to FIG. 6, in an interval from T00 to T01, the word line WL0 is made active at logic HIGH (Vcc), the main decoder signal S0-0 and the pre-decoder signal S10 being at logic LOW (Vss) and the other signals at logic HIGH. At a timing between T01 and T02, the pre-decoder signal S10 is turned to HIGH and another pre-decoder signal S11 is turned to LOW, the other signals remaining unchanged, for making active the word line WL1 instead of the word line WL0. Thus, every of the 2¹⁰ word lines, for example, is selected by making at logic LOW one of the pre-decoder signals S10 to S13 and one of the main decoder signals S0-0 to S0-255. Here, logic HIGH corresponds to a high level power supply voltage Vcc, while logic LOW corresponding to a negative power supply voltage Vss.

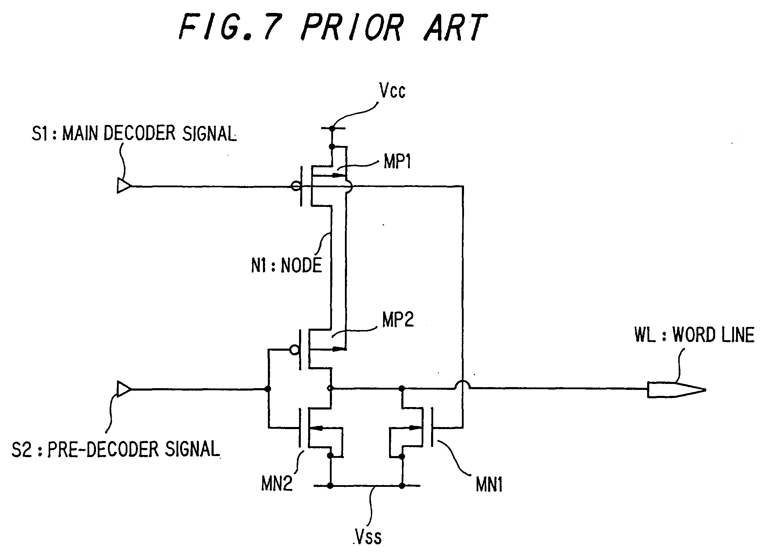

FIG. 7 is a circuit diagram illustrating a conventional NOR gate applied to the NOR gates NOR0 to NOR7 of FIG. 5.

Referring to FIG. 7, the conventional NOR gate comprises a serial connection of two pMOS transistors MP1 and MP2, and a parallel connection of two nMOS transistors MN1 and MN2. The pMOS transistor MP1 has a source connected to a positive power supply Vcc and a drain connected to a node N1, where source of the pMOS transistor MP2 connected. Drain of the pMOS transistor MP2 is connected to drains of the parallel connection of the two nMOS transistors MN1 and MN2 having sources connected to a negative power supply Vss.

Gates of the pMOS transistor MP1 and the nMOS transistor MN1 are connected with each other and supplied with a main decoder signal S1, while gates of the pMOS transistor MP2 and the nMOS transistor MN2, also connected with each other, are supplied with a pre-decoder signal S2. A word line WL is connected to the drains of the pMOS transistor MP1 and the nMOS transistors MN1 and MN2.

When the main decoder signal S1 and the pre-decoder signal S2 are both at logic LOW, both of the pMOS transistors MP1 and MP2 become ON, and both of the nMOS transistors MN1 and MN2 become OFF, making the word line WL active supplied with the positive power supply Vcc.

When either or both of the main decoder signal S1 and the pre-decoder signal S2 is at logic HIGH, either or both of the nMOS transistors MN1 and MN2 becomes ON and either or both of the pMOS transistor MP1 and MP2 becomes OFF, which makes the word line WL inactive grounded to the negative power supply Vss.

However, the conventional NOR gate of FIG. 7 has a problem that potential rising up of a selected word line is made delay a little when the conventional NOR gate is applied to a sub-decoder circuit such as illustrated in FIG. 5.

An example of the problem will be described referring to FIGs. 7 to 9.

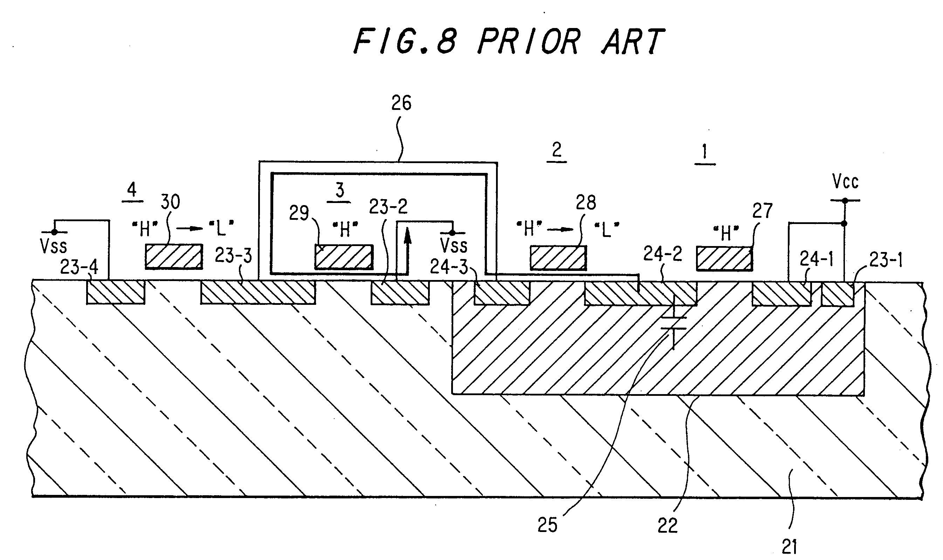

FIG. 8 is a schematic diagram illustrating cross-sectional view of the conventional NOR gate of FIG. 7, wherein a numeral 21 denotes a substrate of a semiconductor wafer, a numeral 22 denotes an n-well, numerals 23-1 to 23-4 denote n⁺ diffusion layers and numerals 24-1 to 24-3 denote p⁺ diffusion layers. Numerals 1 and 2 denote pMOS transistors having gate electrodes 27 and 28 corresponding to the pMOS transistors MP1 and MP2, and numerals 3 and 4 denote nMOS transistors having gate electrodes 29 and 30 corresponding to the nMOS transistors MN1 and MN2, respectively, and a drain electrode 24-3 of the pMOS transistor 2 is wire-connected through a path 26 to a common drain electrode 23-3 of the nMOS transistors 3 and 4.

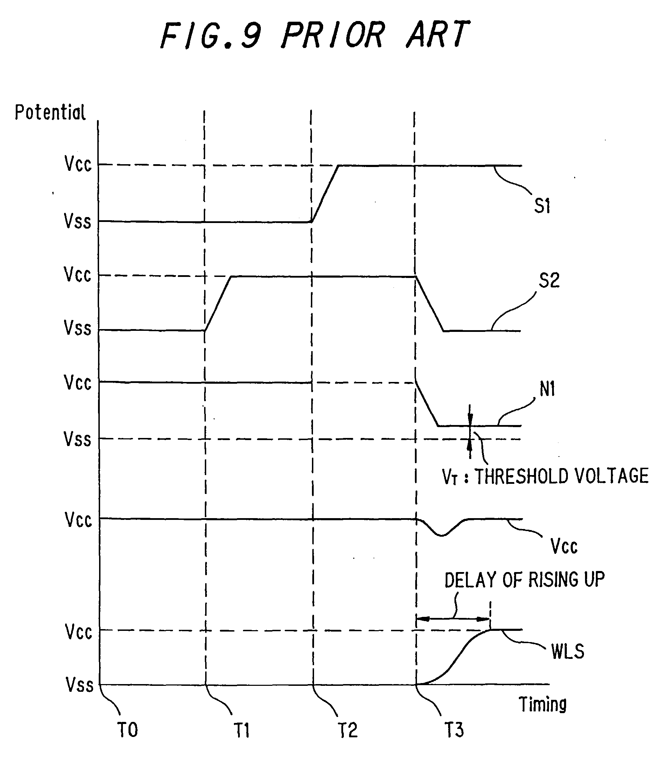

FIG. 9 is a timing chart illustrating relation among potential transitions of the main decoder signal S1, the pre-decoder signal S2, the node N1, the positive power supply Vcc and the selected word line WLS.

In the example illustrated in FIG. 9, logic of the main decoder signal S1 and the pre-decoder signal S2 is changed from a first state (LOW, LOW) between timings T0 and T1, to a second state (LOW, HIGH) at the timing T1, then to a third state (HIGH, HIGH) at a timing T2, and to a fourth state (HIGH, LOW) at a timing T3, according to a transition of the word line address signal.

In the first and the second state where the main decoder signal S1 is at logic LOW, the node N1 is charged with the positive power supply Vcc, the pMOS transistor MP1 being ON. In the third state (HIGH, HIGH), the node N1 is left floating charged with a potential of the positive power supply Vcc as illustrated with a dash line in FIG. 9, both the pMOS transistors MP1 and MP2 being OFF. Therefore, when logic of the main decoder signal S1 and the pre-decoder signal S2 is changed from the third state (HIGH, HIGH) to the fourth state (HIGH, LOW) at the timing T3, the node N1 is discharged in an instant, being connected to the negative power supply Vss through the pMOS transistor MP2 becoming ON and the nMOS transistor MN1 remaining ON.

Referring to FIG. 8, potentials of gate electrodes 28 and 30 change from HIGH to LOW at the timing T3, as illustrated with "H" → "L" in the drawing, other gate electrodes remaining at logic HIGH. Therefore, an electric charge of the p⁺ diffusion layer 24-2 corresponding to the node N1, which has a junction capacitance 25 to the n-well 22 connected to the positive power supply Vcc, is discharged through the path 26, making potential of the n-well 22 and accordingly potential of the positive power supply Vcc drop for a moment, as illustrated in FIG. 9.

Now, a number of NOR gates where the node N1 is discharged in an instance is considered in the sub-decoder 403 of FIG. 4 by way of example, wherein 256 main decoder signals S0-0 to S0255 and four pre-decoder signals S10 to S13 are supplied.

In the example of FIG. 9, logic of the main decoder signal S1 and the pre-decoder signal S2 is changed from the first state (LOW, LOW) to the fourth state (HIGH, LOW) through the second state (LOW, HIGH) and the third state (HIGH, HIGH). The node N1 is charged in the first or the second state where the main decoder signal S1 is at logic LOW and discharged at beginning of the fourth state (HIGH, LOW).

However, the node N1 is charged also in the third state (HIGH, HIGH) with a sub-threshold current flowing through source to drain of the pMOS transistor MP1, especially in semiconductor memories having deep-submicron MOS transistors with small threshold voltage.

Therefore, the instantaneous discharge of the node N1 occurs even when the logic of the main decoder signal S1 and the pre-decoder signal S2 is changed from the fourth state (HIGH, LOW) to the fourth state (HIGH, LOW) through the third state (HIGH, HIGH) without passing the first or the second state, that is, without the pMOS transistor MP1 becoming ON. So, when a word line is selected according to a word line address signal, the instantaneous discharge of the node N1 occurs in NOR gates wherein logic of the main decoder signal S1 and the pre-decoder signal S2 is changed to the fourth state (HIGH, HIGH) from one of the first state (LOW, LOW), the second state (LOW, HIGH) and the third state (HIGH, HIGH).

When the memory cell array 404 is selected, one of the 256 main decoder signals S0-0 to S0-255 and one of the four pre-decoder signals S10 to S13 are at logic LOW. In the case, numbers of NOR gates in each state, of the sub-decoder 403 having 2¹⁰ = 1024 NOR gates, are as follows;
first state (LOW, LOW): 1,
second state (LOW, HIGH): 3,
third state (HIGH, HIGH): 255 × 3, and
fourth state (HIGH, LOW): 255.

Therefore, average number of NOR gates where the node N1 is discharged instantaneously amounts (1 + 3 + 3 × 255) × 255/1024 ≈ 192, which becomes 255 when there are other memory cell arrays and the concerning memory cell array 404 is not selected in succession.

As heretofore described, in sub-decoder circuits consisting of the conventional NOR gates of FIG. 7, the instantaneous discharge of the node N1 occurs in about 1/5 to 1/4 NOR gates every time when a word line is selected, which drops potential of the positive power supply Vcc to be supplied to the selected word line, making delay rising up of the word line as illustrated in FIG. 9.

This is a problem.

Therefore, the object of the present invention is to eliminate the instantaneous drop of the positive power supply Vcc due to the discharge of the node N1, that is, the p⁺ diffusion layer 24-2 having the junction capacitance with the n-well 22, thereby accelerating rising up of the word lines to improve performance of the semiconductor memory.

In order to achieve the object, a NOR gate according to an embodiment of the invention to be applied to a sub-decoder of a semiconductor memory comprises:
a first pMOS transistor, a source thereof connected to a positive power supply, a drain thereof connected to a node and a gate thereof controlled with a main decoder signal;
a second pMOS transistor for obtaining an output signal from a drain thereof, a source thereof connected to a drain of the first pMOS transistor, a gate thereof controlled with a pre-decoder signal;
a parallel connection of a first nMOS transistor and a second nMOS transistor, drains thereof connected to the drain of the second pMOS transistor, sources thereof connected to a negative power supply, and each gate thereof controlled each of the main decoder signal and the pre-decoder signal; and
a third nMOS transistor, a drain thereof connected to the node, a source thereof connected to the negative power supply, and a gate thereof controlled with the main decoder signal.

Therefore, the instantaneous discharge of the node is almost eliminated in the invention, enabling a sharp rising up of word line potential.

The foregoing, further objects, features, and advantages of this invention will become apparent from a consideration of the following description, the appended claims, and the accompanying drawings wherein the same numerals indicate the same or the corresponding parts.

In the drawings:
FIG. 1 is a circuit diagram illustrating a NOR gate according to an embodiment of the invention to be applied to a sub-decoder circuit;
FIG. 2 is a timing chart illustrating relation among potential transitions according to the embodiment of FIG. 1 of a main decoder signal S1, a pre-decoder signal S2, a node N1, a positive power supply Vcc and a selected word line WLS;
FIG. 3 is a circuit diagram of a three input NOR gate according to another embodiment of the invention;
FIG. 4 is a block diagram illustrating a typical configuration of a decoder circuit for driving word lines of a memory cell array;
FIG. 5 is a circuit diagram illustrating a part of the sub-decoder 403 of FIG. 4;
FIG. 6 is a timing chart illustrating a transition of logic of the main decoder signals S0-0 and S0-1 and the pre-decoder signals S10 to S13 of FIG. 5 when the selected word line changes from a word line WL0 to another word line WL1;
FIG. 7 is a circuit diagram illustrating a conventional NOR gate applied to the NOR gates NOR0 to NOR7 of FIG. 5;
FIG. 8 is a schematic diagram illustrating cross-sectional view of the conventional NOR gate of FIG. 7; and
FIG. 9 is a timing chart illustrating relation among potential transitions in the conventional NOR gate of FIG. 7 of the main decoder signal S1, the pre-decoder signal S2, the node N1, the positive power supply Vcc and the selected word line WLS.

Now, embodiments of the present invention will be described in connection with the drawings.

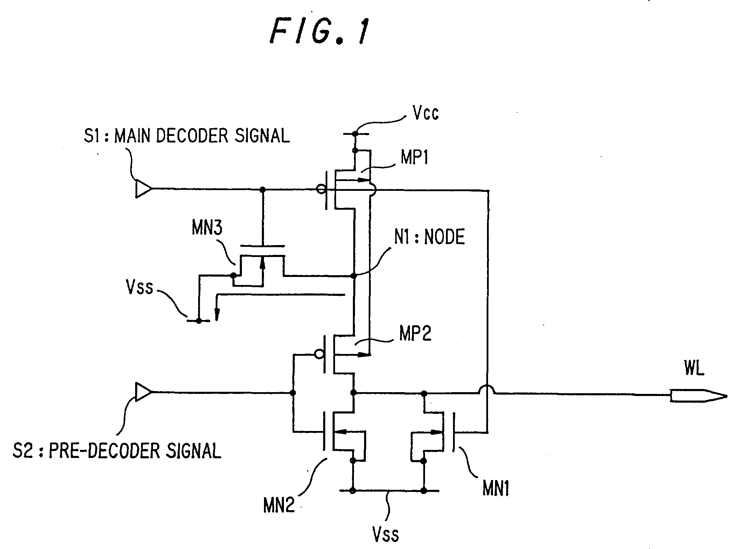

FIG. 1 is a circuit diagram illustrating a NOR gate according to an embodiment of the invention to be applied to the sub-decoder circuit.

Referring to FIG. 1, the NOR gate comprises;
a first pMOS transistor MP1, a source thereof connected to a positive power supply Vcc, a drain thereof connected to a node N1 and a gate thereof controlled by a main decoder signal S1,
a second pMOS transistor MP2, a source thereof connected to the node N1, drain there of connected to a word line WL and a gate thereof controlled by a pre-decoder signal S2,
a parallel connection of a first and a second nMOS transistors MN1 and MN2, drains thereof connected to the drain of the second pMOS transistor MP2, sources thereof connected to a low level power supply Vss and gates thereof controlled by the main decoder signal S1 and the pre-decoder signal S2, respectively, and
a third nMOS transistor MN3, a source thereof connected to the low level power supply Vss, a drain thereof connected to the node N1 and a gate thereof controlled by the main decoder signal S1.

When the main decoder signal S1 and the pre-decoder signal S2 are both at logic LOW, both of the first and the second pMOS transistor MP1 and MP2 become ON, and both of the first and the second nMOS transistors MN1 and MN2 become OFF, making the word line WL active supplied with the high level power supply Vcc. When either or both of the main decoder signal S1 and the pre-decoder signal S2 is at logic HIGH, either or both of the first and the second nMOS transistor MN1 and MN2 becomes ON and either or both of the pMOS transistors MP1 and MP2 becomes OFF, which makes the word line WL inactive grounded to the low level power supply Vss. Thus, the NOR gate of FIG. 1 controls the word line WL according to logic of the main decoder signal S1 and the pre-decoder signal S2, in the same way with the conventional NOR gate 11 of FIG. 7.

However, when logic of the main decoder signal S1 is at logic HIGH, the third nMOS transistor MN3 becomes ON and the node N1 is connected to the low level power supply Vss, in the embodiment.

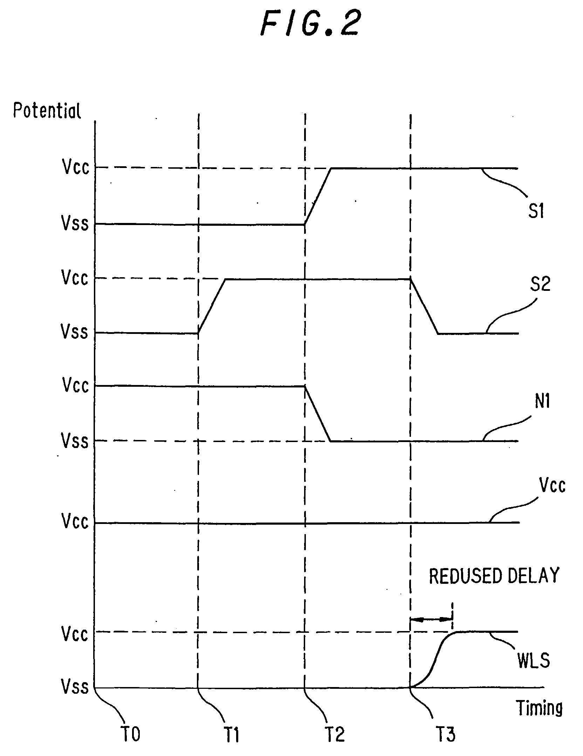

FIG. 2 is a timing chart illustrating relation among potential transitions, according to the embodiment, of the main decoder signal S1, the pre-decoder signal S2, the node N1, the high level power supply Vcc and the selected word line WLS.

In the example illustrated in FIG. 2, logic of the main decoder signal S1 and the pre-decoder signal S2 is changed from a first state (LOW, LOW) between timings T0 and T1, to a second state (LOW, HIGH) at the timing T1, then to a third state (HIGH, HIGH) at a timing T2, and to a fourth state (HIGH, LOW) at a timing T3, according to a transition of the word line address signal, in the same way to the example of FIG. 9.

In the first and the second state where the main decoder signal S1 is at logic LOW, the node N1 is charged with the positive power supply Vcc, the pMOS transistor MP1 being ON. In the third state (HIGH, HIGH), the node N1 is discharged to the negative power supply Vss as illustrated in FIG. 2 through the third nMOS transistor MN3 becoming ON, in the NOR gate of FIG. 1. Therefore, when logic of the main decoder signal S1 and the pre-decoder signal S2 is changed from the third state (HIGH, HIGH) to the fourth state (HIGH, LOW) at the timing T3, the instantaneous discharge of the node N1 does not occur.

Therefore, there is no potential drop of the positive power supply Vcc to be supplied to a selected word line WLS at the timing T3, enabling a sharp rising up of the selected word line WLS.

On the other hand, discharge of the node N1 occurs at the timing T2, that is, when logic of the main decoder signal S1 and the pre-decoder signal S2 is changed from the second state (LOW, HIGH) to the third state (HIGH, LOW), in the example of FIG. 2.

The node N1 is charged in the first and the second state and it is connected to the negative power supply Vss in the fourth state through the pMOS transistor MP2 and the second nMOS transistor MN2, and also in the third state through the third nMOS transistor MN3, in the embodiment. So, the instantaneous discharge of the node N1 occurs when logic of the main decoder signal S1 and the pre-decoder signal S2 is changed from either of the first and the second state to either of the third and the fourth state.

However, numbers of NOR gates in each state, of the sub-decoder 404 having 2¹⁰ = 1024 NOR gates, are as follows as previously described when the memory cell array 403 is selected;
first state (LOW, LOW): 1,
second state (LOW, HIGH): 3,
third state (HIGH, HIGH): 255 × 3, and
fourth state (HIGH, LOW): 255.

Therefore, average number of NOR gates where the node N1 is discharged instantaneously, when a word line is selected, is reduced to (1 + 3) × (1 + 3) × 255/1024 ≈ 4, which becomes 0 when there are other memory cell arrays and the concerning memory cell array 404 is not selected in succession.

Thus, by providing the third nMOS transistor MN3 for discharging the node N1 when the first transistor MP1 is OFF, including charging with the sub-threshold current of the pMOS transistor MP1, the instantaneous discharge of the node N1 can be almost eliminated, enabling a sharp rising up of the selected word line WSL as illustrated in FIG. 2, in the embodiment.

As for the third nMOS transistor MN3, it needs little space on the semiconductor wafer since it is sufficient with a dimension to bypass the floating charge.

Heretofore, the present invention is described in connection with the two input NOR gate of FIG. 1. However, various applications and modifications can be considered in the scope of the invention.

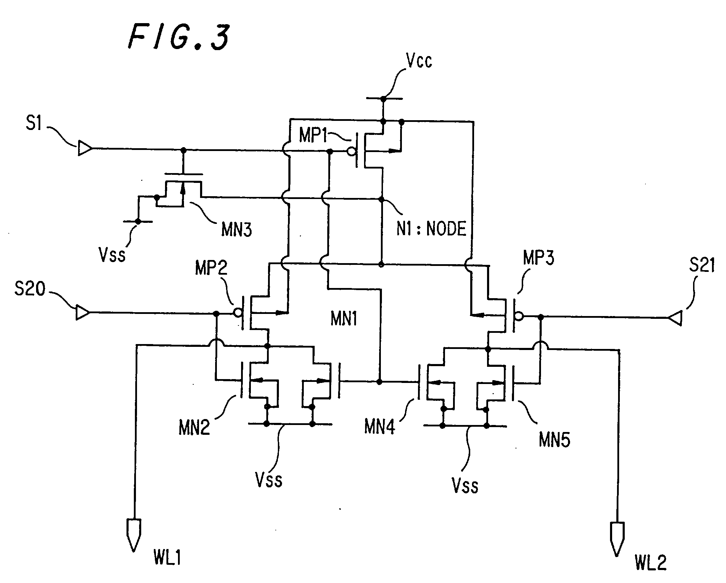

FIG. 3 is a circuit diagram of a three input NOR gate according to another embodiment of the invention, wherein, in addition to the circuit configuration of FIG. 1, further comprised;
a third pMOS transistor MP3, a source thereof connected to the drain of the first pMOS transistor MP1, namely the node N1, a drain thereof connected to a second word line WL2, a gate thereof controlled by a second pre-decoder signal S21, and
a parallel connection of a fourth and a fifth nMOS transistor MN4 and MN5, drains thereof connected to the drain of the third pMOS transistor MP3, sources thereof connected to a low level power supply Vss and gates thereof controlled by the main decoder signal S1 and the second pre-decoder signal S21, respectively.

A first pre-decoder signal S20 is supplied to the gate of the second pMOS transistor MP2 for controlling a first word line WL1, in FIG. 3.

When logic of the main decoder signal S1 is HIGH, the first pMOS transistor MP1 is OFF and the first and the fourth nMOS transistor MN1 and MN4 is ON, making both the first and the second word line WL1 and WL2 inactive.

When logic of the main decoder signal S1 is LOW, the first or the second word line WL1 or WL2 is made active when the first or the second pre-decoding signal S20 or S21 is at logic LOW.

In the embodiment of FIG. 3, the third nMOS transistor MN3 becoming ON, it connects the node N1 to the low level power supply Vss, when the main decoder signal S1 turns to OFF, bypassing the floating charge of the node N1. Therefore, the instantaneous discharge of the node N1 can be prevented, in the same way with the embodiment of FIG. 1, with a half number of bypassing nMOS transistors MN3, compared to the embodiment of FIG. 1.

## Claims

1. A NOR gate applied to a sub-decoder (403) of a semiconductor memory comprising:
a first MOS transistor (MP1) of a first conductivity type, a source thereof connected to a first power supply (Vcc), a drain thereof connected to a node (N1) and a gate thereof controlled with a first input signal (S1);
a second MOS transistor (MP2) of the first conductivity type for obtaining an output signal from a drain thereof, a source thereof connected to a drain of said first MOS transistor (MP1), a gate thereof controlled with a second input signal (S2);
a parallel connection of a third MOS transistor (MN1) of a second conductivity type and a fourth MOS transistor (MN2) of the second conductivity type, drains thereof connected to said drain of said second MOS transistor (MP2), sources thereof connected to a second power supply (Vss), and each gate thereof controlled each of said first input signal (S1) and said second input signal (S2); and
a discharge circuit for discharging said node (N1) when said first MOS transistor (MP1) is controlled to be off.

2. The NOR gate recited in claim 1, wherein said discharge circuit comprises a fifth MOS transistor (MN3) of the second conductivity type, a drain thereof connected to said node (N1), a source thereof connected to said second power supply (Vss), and a gate thereof controlled with said first input signal (S1).

3. A NOR gate applied to a sub-decoder (403) of a semiconductor memory comprising:
a first MOS transistor (MP1) of a first conductivity type, a source thereof connected to a first power supply (Vcc), a drain thereof connected to a node (N1) and a gate thereof controlled with a first input signal (S1);
a discharge circuit for discharging said node (N1) when said first MOS transistor (MP1) is controlled to be off;
a plurality of gate circuits, each of said plurality of gate circuits comprising a second MOS transistor (MP2, MP3) of the first conductivity type for obtaining each of output signals from a drain thereof, a source thereof connected to a drain of said first MOS transistor (MP1), a gate thereof controlled with each of second input signals (S20, S21), and a parallel connection of a third MOS transistor (MN1, MN4) of a second conductivity type and a fourth MOS transistor (MN2, MN4) of the second conductivity type, drains thereof connected to said drain of said second MOS transistor (MP2, MP3), sources thereof connected to a second power supply (Vss), and each gate thereof controlled with said first input signal (S1) and said each of said second input signals (S20, S21), respectively.

4. The NOR gate recited in claim 3, wherein said first input signal is supplied from a main decoder (402) of the semiconductor memory, said second input signals are supplied from a pre-decoder (401) of the semiconductor memory and said output signals are supplied to word lines of a memory cell array (404) of the semiconductor memory.
